Europäisches Patentamt

European Patent Office

Office européen des brevets

(19)

(11) Numéro de publication : **0 504 015 A1**

# (12) DEMANDE DE BREVET EUROPEEN

(21) Numéro de dépôt : **92400574.7**

(22) Date de dépôt : **05.03.92**

(51) Int. Cl.⁵ : **H03D 3/24**

(30) Priorité : **08.03.91 FR 9102816**

(43) Date de publication de la demande :
**16.09.92 Bulletin 92/38**

(84) Etats contractants désignés :
**DE ES FR GB IT**

(71) Demandeur : **ALCATEL ESPACE**
**11, avenue Dubonnet**
**F-92407 Courbevoie Cédex (FR)**

(72) Inventeur : **Tonello, Emile**
**4, rue Edith Piaf**
**F-31100 Toulouse (FR)**
Inventeur : **Herbere, Christian**
**35, avenue Montaigne**
**F-31830 Plaisance du Touch (FR)**

(74) Mandataire : **Weinmiller, Jürgen et al**
**Lennéstrasse 9 Postfach 24**
**W-8133 Feldafing (DE)**

(54) **Récepteur de signaux modulés en fréquence à bande d'accrochage controlée.**

(57)    La présente invention se rapporte à un récepteur de signaux modulés en fréquence à bande d'accrochage controlée comportant :
— un démodulateur à boucle de phase (40),
— un circuit de translation de fréquence (30) comportant un filtre de fréquence intermédiaire (36) ;
— une boucle de recentrage (44) du signal reçu dans ce filtre (36) ;
Application notamment au domaine des télécommunications spatiales.

FIG.2

EP 0 504 015 A1

Jouve, 18, rue Saint-Denis, 75001 PARIS

L'invention concerne un récepteur de signaux modulés en fréquence à bande d'accrochage contrôlée.

Dans certains récepteurs à boucle de phase les performances doivent pouvoir être tenues dans un environnement très fortement brouillé; c'est-à-dire avec des signaux parasites très proches en fréquence du signal utile et d'un niveau de puissance très élevé (par exemple ± 2,6 MHz avec un rapport brouilleur à signal B/S ≧ 50 dBc. Pour certains de ces récepteurs, ces performances doivent pouvoir être maintenues dans un environnement spatial, ce qui pose alors des problèmes liés à la température, au vieillissement...

Ces performances sont optimales quand le signal qui attaque le circuit de démodulation est parfaitement centré dans le filtre de fréquence intermédiaire (FI). Il est donc nécessaire d'utiliser un système qui recentre automatiquement le signal reçu sur la fréquence centrale de ce filtre FI.

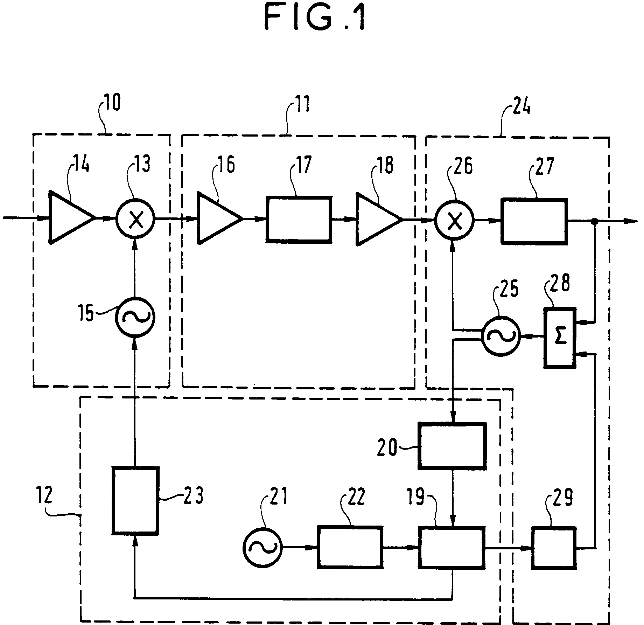

La demande de brevet français FR 2596220 décrit un démodulateur de fréquence de l'art connu, comprenant un circuit de sélection de canal, un circuit de sélection de fréquence intermédiaire et un circuit de contrôle automatique de fréquence, qui va être décrit ci-dessous au regard de la figure 1.

Un tel démodulateur présente un certain nombre d'inconvénients :

– il n'est protégé des brouilleurs de très fort niveau que par la qualité du filtre de fréquence intermédiaire.

– il comporte trois boucles d'asservissement qui nécessitent, chacune, des réglages de bande passante.

La demande de brevet GB-A-2 79 552 décrit un système de réception de signaux modulés en fréquence à double boucle à verrouillage de phase, comprenant un circuit de translation de fréquence ayant un filtre de fréquence intermédiaire et un circuit de décision de la fermeture de la boucle de phase. La décision de fermeture de la boucle de phase de ce dispositif se fait uniquement à partir d'une détection de verrouillage.

Un tel démodulateur présente, lui aussi, une protection insuffisante au brouillage, assurée uniquement par le filtre de fréquence intermédiaire. En outre, il n'est pas prévu de connaître la nature du signal ayant provoqué l'accrochage, avant de fermer la boucle de phase, permettant la fermeture de la boucle dès la détection de verrouillage indifféremment sur un brouilleur ou sur un signal.

L'invention a pour objet de pallier ces inconvénients. Elle propose , à cet effet, un récepteur de signaux modulés en fréquence à bande d'accrochage controlée comportant un démodulateur à boucle de phase, ledit récepteur étant caractérisé en ce qu'il comprend :

– un circuit de translation de fréquence comportant un filtre de fréquence intermédiaire;

– une boucle de recentrage du signal reçu dans ce filtre.

Avantageusement, ce récepteur comporte en outre un circuit de décision de fermeture de la boucle de recentrage.

Dans une réalisation avantageuse du récepteur de l'invention, le circuit de translation de fréquence comporte successivement entre son entrée, qui est l'entrée du récepteur, et sa sortie :

. un amplificateur;

. un filtre réjecteur de fréquence image;

. un mélangeur qui reçoit un signal issu d'un VCO ("Voltage Control Oscillator");

. un premier amplificateur à commande de gain;

. un filtre FI passe-bande;

. un second amplificateur à commande de gain;

. un coupleur qui est relié à un circuit de régulation de niveau FI qui commande les deux amplificateurs à commande de gain.

Le démodulateur de fréquence à boucle de phase comprend successivement :

. un mélangeur;

. un amplificateur filtre de boucle dont la sortie est la sortie du récepteur; un oscillateur étant connecté entre cette sortie et une seconde entrée du mélangeur.

La boucle de recentrage comprend successivement :

. un oscillateur de référence dont la fréquence est en rapport K avec la fréquence du filtre FI (FI/K);

. un premier diviseur de fréquence programmable;

. un comparateur phase/fréquence qui reçoit sur une seconde entrée le signal issu d'un coupleur positionné en sortie de l'oscillateur du démodulateur de fréquence à boucle de phase, au travers d'un second diviseur de fréquence programmable;

. un filtre de boucle;

. un interrupteur commandable électriquement dont la sortie est reliée au VCO du circuit de translation de fréquence.

Le circuit de décision de fermeture de la boucle de recentrage comprend un circuit détecteur d'écart de fréquence, recevant sur ses deux entrées les signaux sortant des deux diviseurs de fréquence programmables, suivi d'un circuit détecteur d'accrochage qui reçoit sur une seconde entrée un signal issu d'un circuit indicateur de verrouillage du démodulateur dont les entrées sont reliées aux deux coupleurs; ce circuit de détection d'accrochage commandant, d'une part, l'interrupteur et délivrant, d'autre part, un signal indicateur de "récepteur prêt".

Les caractéristiques et avantages de l'invention ressortiront d'ailleurs de la description qui va suivre, à titre d'exemple non limitatif, en référence aux figures annexées sur lesquelles :

– la figure 1 illustre un démodulateur de fréquence de l'art connu;

– la figure 2 illustre le récepteur de signaux modulés en fréquence selon l'invention.

Le démodulateur de l'art connu, décrit dans la demande de brevet français FR 2596220, comprend un circuit de sélection de canal 10, un circuit de sélection de fréquence intermédiaire 11, et un circuit de contrôle automatique de fréquence 12. Le circuit de sélection de canal 10 comprend un mélangeur 13 dont les entrées sont reliées d'une part à un amplificateur 14 recevant le signal modulé en fréquence à une fréquence porteuse déterminée et d'autre part à un oscillateur 15. Le circuit de sélection de fréquence intermédiaire 11 est composé d'un amplificateur 16, d'un filtre passe-bande 17 et d'un circuit de commande automatique de gain 18, prévus en série. Le circuit de commande automatique de fréquence 12 comprend un comparateur 19 recevant d'une part le signal à la fréquence à comparer, par l'intermédiaire d'un premier diviseur de fréquence 20, et d'autre part un signal à une fréquence de référence, par l'intermédiaire d'un oscillateur de référence 21 et d'un deuxième diviseur de fréquence 22. La sortie du comparateur 19 est envoyée vers un intégrateur 23 qui génère le signal de tension de commande de l'oscillateur 15 du circuit de sélection de canal. Ce démodulateur comprend, de plus, en sortie du circuit de sélection de fréquence intermédiaire 11, une boucle à verrouillage de phase 24 équipée d'un oscillateur 25 commandé en tension, d'un mélangeur 26 recevant, d'une part, la sortie du circuit de sélection de fréquence intermédiaire 11 et, d'autre part, celle de l'oscillateur 25, et d'un filtre de boucle 27, cette boucle 24 étant, en outre, équipée, en amont de son oscillateur 25, d'un circuit de correction de tension de commande, qui comprend un additionneur 28 dont la sortie est reliée à l'entrée dudit oscillateur 25 de la boucle et dont les entrées sont reliées d'une part à la sortie de la boucle 24, qui est aussi celle du démodulateur (S), et d'autre part à la sortie d'un générateur de tension de correction, qui comprend un deuxième intégrateur 29 relié à la sortie du comparateur 19.

Ce démodulateur fonctionne comme suit :

– En absence de signal utile la boucle formée des éléments numérotés 25, 20, 19, 29 et 28 assure la stabilité de la fréquence de l'oscillateur 25 du démodulateur à boucle de phase.

– En présence d'un signal utile à l'entrée du récepteur le démodulateur à boucle de phase 24 verrouille, sur le signal translaté et filtré par le mélangeur 26 et l'oscillateur 25. La boucle formée par les éléments 13, 16, 17, 18, 26, 25, 20, 19, 23 et 15 recentre le signal FI dans le filtre 17 en décalant la fréquence de l'oscillateur 15.

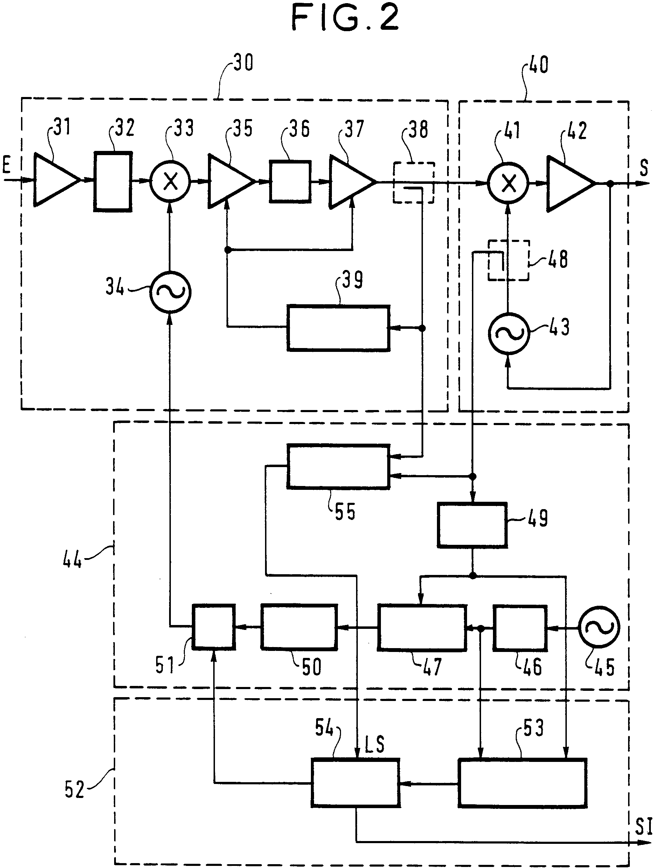

Le récepteur de l'invention, tel que représenté sur la figure 2, comprend :

– un circuit de translation de fréquence 10 comportant successivement entre son entrée, qui est l'entrée E du récepteur, et sa sortie :

. un amplificateur 31;

. un filtre réjecteur de fréquence image 32;

. un mélangeur 33 qui reçoit un signal issu d'un VCO ("Voltage Controlled Oscillator") 34;

. un premier amplificateur à commande de gain 35;

. un filtre FI passe-bande 36;

. un second amplificateur à commande de gain 37;

. un coupleur 38, qui est relié à un circuit 39 de régulation de niveau FI, qui commande les deux amplificateurs à commande de gain 35 et 37;

– un démodulateur de fréquence à boucle de phase 40 comprenant successivement :

. un mélangeur 41;

. un amplificateur filtre de boucle 42 dont la sortie est la sortie S du récepteur; un oscillateur 43 étant connecté entre cette sortie et une seconde entrée du mélangeur 41.

– une boucle de recentrage du signal reçu et translaté dans le filtre FI 44 qui comprend successivement :

. un oscillateur 45 de référence dont la fréquence est en rapport K avec la fréquence du filtre FI 36 (FI/K);

. un premier diviseur de fréquence programmable 46;

. un comparateur 47 phase/fréquence qui reçoit sur une seconde entrée le signal issu d'un coupleur 48 positionné en sortie de l'oscillateur 43 du démodulateur de fréquence à boucle de phase 40, au travers d'un second diviseur de fréquence programmable 49;

. un filtre de boucle 50;

. un interrupteur 51 commandable électriquement dont la sortie est relié au VCO du circuit de translation 30.

– un circuit 52 de décision de fermeture de la boucle de recentrage 44, comprenant un circuit détecteur d'écart de fréquence 53 recevant sur ses deux entrées les signaux sortant des deux diviseurs de fréquence programmable 46 et 49, suivi d'un circuit détecteur d'accrochage 54 qui reçoit sur une seconde entrée LS un signal issu d'un circuit indicateur de verrouillage du démodulateur 55 dont les entrées sont reliées aux deux coupleurs 38 et 48; ce circuit de détection d'accrochage 54 commandant, d'une part, l'interrupteur 51 et délivrant, d'autre part, un signal indicateur SI de "récepteur prêt".

Le circuit de translation 30 a pour but de translater, filtrer et réguler le signal à l'entrée du démodulateur de fréquence 40. Ce circuit 30 est tel qu'en l'absence de signal à l'entrée du récepteur, le niveau de bruit injecté à l'entrée du démodulateur 40 permette que la fréquence de l'oscillateur 43 reste à la fréquence centrale du filtre passe-bande FI 36. De ce fait une boucle d'asservissement est inutile.

Les deux diviseurs de fréquence programmable 46 et 49 ont pour rôle d'optimiser le compromis indice de modulation/vitesse de décision.

Le comparateur phase/fréquence 47 sert de détecteur à la boucle de recentrage 44.

L'interrupteur 51 impose une tension constante à l'oscillateur 34 quand il est ouvert et ferme la boucle de recentrage 44 quand le circuit 53 le commande. Ce circuit d'écart de fréquence 53 permet, en effet, d'évaluer l'écart de fréquence entre la fréquence du signal présent à l'entrée E du récepteur et la fréquence de référence du signal issu de l'oscillateur 45.

Le récepteur de l'invention, ainsi défini, fonctionne de la façon suivante :

. en l'absence de signal à l'entrée E du récepteur, le circuit de translation de fréquence 30 présente à l'entrée du démodulateur à boucle de phase 40 un niveau de bruit tel que l'oscillateur 43 de ce démodulateur 40 reste centré sur la fréquence moyenne du signal donc sur la fréquence centrale du filtre de fréquence intermédiaire 36. Il n'est donc pas nécessaire d'inclure dans le récepteur un dispositif de centrage de cet oscillateur 43. Le circuit 55 ne délivre pas l'information d'accrochage du démodulateur et le circuit de décision 52 ne ferme pas la boucle de recentrage 44.

. En présence d'un brouilleur de très fort niveau (par exemple 50dB au-dessus du niveau minimum de réception) le démodulateur à boucle de phase 40 se verrouille sur ce brouilleur et l'information de verrouillage LS est valide. Le détecteur d'écart de fréquence 53 mesure la valeur de l'écart de fréquence. Cet écart est supérieur à une valeur consigne (qui peut être réglable) le circuit de décision 52 n'autorise pas la fermeture de la boucle de recalage 44. Le récepteur reste donc centré sur sa fréquence nominale de réception même en présence d'un brouilleur de très fort niveau.

. En présence d'un signal utile décalé (pour cause d'effet "doppler", ou par effet du vieillissement ou de la température) le démodulateur à boucle de phase 40 se verrouille sur le signal FI. L'information de verrouillage LS est valide. Le détecteur d'écart de fréquence 53 autorise la fermeture de la boucle de recentrage 44 qui recentre, par action sur le VCO 34, le signal reçu et translaté dans le filtre FI 36. Les performances de démodulation sont donc optimales quelles que soient les variations de fréquence du signal d'entrée et donc de l'oscillateur VCO 34.

L'utilisation d'un récepteur, tel que celui qui vient d'être décrit, est nécessaire dans un environnement très fortement brouillé (par exemple avec des brouilleurs à quelques MHz ayant un niveau de 50 db au-dessus du signal utile) où il faut contrôler précisément la boucle d'acquisition. L'incertitude de la plage d'acquisition peut être de l'ordre de quelques pourcent.

Le réglage optimal des rangs de division des diviseurs 46 et 49 permet d'ajuster le compromis indice de modulation/temps de décision.

A titre d'exemple, avec un indice de modulation voisin de 1500 le temps de décision est d'environ 75 ms et le temps d'indication "Récepteur pret" d'environ de 1 seconde dans le cas d'un signal utile en limite de bande d'acquision (800 kHz).

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

Ainsi dans le cas d'utilisation dans un environnement moins brouillé, le circuit de décision 52 peut être supprimé, l'interrupteur 51 est alors commandé par le circuit indicateur de verrouillage 55. Ce système plus simple centre le signal reçu tout aussi efficacement, mais ne garantit pas la tenue aux brouilleurs très forts. Une limitation électrique de la tension de commande du VCO 34 permet d'éviter que le récepteur ne se verrouille malgré tout sur un brouilleur et ne s'éloigne pas trop de la fréquence nominale de réception.

**Revendications**

1) Récepteur de signaux modulés en fréquence à bande d'accrochage controlée comportant un démodulateur à boucle de phase (40), ledit récepteur étant caractérisé en ce qu'il comprend :
– un circuit de translation de fréquence (30) comportant un filtre de fréquence intermédiaire (36);
– une boucle de recentrage (44) du signal reçu dans ce filtre (36).

2) Récepteur selon la revendication 1, caractérisé en ce qu'il comprend un circuit (53) de décision de fermeture de la boucle de recentrage (44).

3) Récepteur selon la revendication 1, caractérisé en ce que le circuit de translation de fréquence (10) comporte successivement entre son entrée, qui est l'entrée (E) du récepteur, et sa sortie
. un amplificateur (31);
. un filtre réjecteur de fréquence image (32);
. un mélangeur (33) qui reçoit un signal issu d'un VCO (34);
. un premier amplificateur à commande de gain (35);
. un filtre FI passe-bande (36);
. un second amplificateur à commande de gain (37);

. un coupleur (38) qui est relié à un circuit (39) de régulation de niveau FI qui commande les deux amplificateurs à commande de gain (35 et 37).

**4)** Récepteur selon la revendication 1, caractérisé en ce que le démodulateur de fréquence à boucle de phase (40) comprend successivement :

. un mélangeur (41);

. un amplificateur filtre de boucle (42) dont la sortie est la sortie (S) du récepteur; un oscillateur (43) étant commandé entre cette sortie et une entrée du mélangeur (41).

**5)** Récepteur selon la revendication 1, caractérisé en ce que la boucle de recentrage (44) comprend successivement :

. un oscillateur de référence (45) dont la fréquence est en rapport K avec la fréquence du filtre FI (36) (FI/K);

. un premier diviseur de fréquence programmable (46);

. un comparateur (47) phase/fréquence qui reçoit sur une seconde entrée le signal issu d'un coupleur (48) positionné en sortie de l'oscillateur (43) du démodulateur de fréquence à boucle de phase (40), au travers d'un second diviseur de fréquence programmable (49);

. un filtre de boucle (50);

. un interrupteur (51) commandable électriquement dont la sortie est reliée au VCO du circuit de translation (36).

**6)** Récepteur selon la revendication 2, caractérisé en ce que le circuit (52) de décision de fermeture de la boucle de recentrage (44) comprend un circuit détecteur d'écart de fréquence (53) recevant sur ses deux entrées les signaux sortant des deux diviseurs de fréquence programmable (46 et 49) suivi d'un circuit détecteur d'accrochage (54) qui reçoit sur une seconde entrée un signal (LS) issu d'un circuit indicateur de verrouillage du démodulateur (55), dont les entrées sont reliées aux deux coupleurs (38 et 48); ce circuit de détection d'accrochage (54) commandant, d'une part l'interrupteur (51) et délivrant d'autre part, un signal indicateur (SI) de "récepteur prêt".

# FIG.1

# FIG.2

EP 0 504 015 A1

Office européen
des brevets

RAPPORT DE RECHERCHE EUROPEENNE

Numero de la demande

EP 92 40 0574

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | GB-A-2 079 552 (PHILIPS ELECTRONIC AND ASSOCIATED INDUSTRIES) | 1,2 | H03D3/24 |
| Y | * page 1, ligne 69 - page 3, ligne 38; figure 1 * | 3-5 | |
| | --- | | |
| D,Y | EP-A-0 238 141 (PORTENSEIGNE) * colonne 2, ligne 1 - colonne 3, ligne 19; figure * | 3-5 | |
| | --- | | |
| A | US-A-4 556 988 (A. YOSHISATO) * colonne 3, ligne 64 - colonne 5, ligne 47; figure 2 * | 3,4 | |
| | --- | | |
| A | WO-A-8 810 033 (MOTOROLA INC) | | |
| | ----- | | |

DOMAINES TECHNIQUES RECHERCHES (Int. Cl.5)

H03D
H03J
H03L

Le présent rapport a été établi pour toutes les revendications

| Lieu de la recherche | Date d'achèvement de la recherche | Examinateur |
|---|---|---|
| LA HAYE | 22 MAI 1992 | DHONDT I.E.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
-----
& : membre de la même famille, document correspondant

EPO FORM 1503 03.42 (P0402)

8